# EUROPEAN PATENT SPECIFICATION

(11) **EP 1 930 371 B1**
(45) Date of publication and mention of the grant of the patent: **02.09.2009**
(21) Application number: 06025011.5
(22) Date of filing: 04.12.2006
(51) Int. Cl.: C08L 9/00, H05K 1/02

(54) **Polybutadiene thermosetting resin printed circuit board composition and the process thereof**
Leiterplatte aus hitzehärtender Polybutadien-Harzzusammensetzung und Verfahren dafür
Composition de carte de circuit imprimé en résine polybutadiène thermodurcissable et son procédé de fabrication

(43) Date of publication of application: 11.06.2008
(73) Proprietor: NAN YA PLASTICS CORPORATION, Taipei (TW)
(72) Inventor: Tzou, Ming-Jen, Taipei (TW)
(74) Representative: Viering, Jentschura & Partner

(56) References cited:
- WO-A-00/10368
- US-A- 5 223 568

## Description

### BACKGROUND OF THE INVENTION

### FIELD OF THE INVENTION:

The present invention relates to a printed circuit board (PCB) material, which is a polybutadiene-based thermosetting resin, with the corporation of a peroxide curing agent or crosslinking agent to form an insulation layer on a copper clad laminate. In accordance with the requirement of the process, inorganic particulate filler with high surface area, such as silica, and a metallic coagent are selectively added into resin matrix. The resulted prepreg shows almost no stickiness, easy to be handled, thus favorable for an automatic process and suitable for a general hot press operation. The obtained prepreg possesses low stickiness, and no slip is found during laminating at the room temperature. The resin composition of the invention is characteristic in the incorporation of a unique metallic coagent; the peeling strength thereof is excellent, thus most suitably applied in high-frequency circuit board.

### DESCRIPTION OF THE RELATED ART

In the previous arts, circuit boards are made from polybutadiene as a main material with addition of non-woven reinforcing cloth, particulate filler, initiator, brominated flame retardant, etc. For example, in USP No. 4,241,132, the composition of circuit boards comprises polybutadiene polymer (70 wt% of 1,2-addition polybutadiene rubber, Ricon 150 Sartomer) and reinforcing fiber, such as polypropylene fiber. In the insulation composition, the dielectric constant or dissipation factor of resin should comply with reinforcing fiber. The disadvantages are as follows:
1. The vinyl content of the polybutadiene used is not enough, thus the strength of the substrate is weak.
2. Flame retardant cannot meet UL94 V-0 regulation.

The PCB composition is disclosed in USP No. 4,997,702 which also includes inorganic fillers or reinforcing fibers with 20 - 70 wt% of total compositions, in addition to epoxy resin, wherein fibers comprise glass fiber or polymer fiber, and fillers comprise particulates clay or minerals, e.g. silica. Its obvious drawbacks are:
1. The substrate manufactured by epoxy resin leads to poor electric properties (Dk, Df), and highly hygroscopic.
2. The use of non-woven cloth deteriorates the mechanical strength of PCB.

The thermosetting composition for circuit board revealed in USP No. 5,223,568 includes:
a. Polybutadiene or polyisoprene resin, which is liquid at room temperature and its molecular weight, is less than 5,000.
b. Polybutadiene or polyisoprene is solid-state copolymer.
c. The high curing temperature is above 250• ; but lower than the thermal decomposed temperature of the composite.

Although the performance of the said circuit boards is not bad, there are still some drawbacks as following:
1. A high curing temperature (the press temperature above 250• ) is needed, but the ordinary service temperature of circuit substrate manufacturing equipment is limited to be under 180• ; and the bromine flame retardant agent incorporated composite can not withstand such a 250• •high temperature, since the high temperature degradation or chemical cracking will lead to physical property deterioration.
2. The prepreg made by said polybutadiene or polyisoprene resin is too sticky to conduct an automatic continuous pressing of PCB.

The circuit board disclosed in the USP No. 6,048,807 comprises:
a. 10-75 vol% of thermosetting resin composition, including polybutadiene or polyisoprene resin with a molecular weight less than 5,000 and a butadiene containing or unsaturated bond diblock polymer;
b. Less than 14 vol% of ethylene propylene liquid rubber with molecular weight less than 50,000, which can be ethylene propylene copolymer or ethylene propylene diene (e.g. dicyclopentadiene or ethylidene norbornene) terpolymer (EPDM) or their compositions;
c. Particulate filler; and
d. Woven cloth.

The disadvantages thereof are:
1. The circuit board can be only obtained via high temperature and pressure (300• ; 500psi and above), and then the bromine-based flame retardant will decompose or degrade to loss flame retardant.
2. The proportion of filler is over 50 wt%, even up to 70 wt%, and then it is difficult to be impregnated with the current equipment, the wearing of drill head during drilling is too much.

The circuit board disclosed in USP No. 6,071,836 is **characterized in that**:
a. High ratio of particulate fillers makes the prepreg nonstick, easy to handle and good for processing;
b. Excellent electric properties (dielectric constant, dissipation factor and dielectric strength), heat insulation and non-electric conductance;
c. Owing to high ratio of particulate fillers, it needs only a small amount of glass fiber reinforcing material to improve CTE of Z-axis direction;
d. To avoid degradation, the temperature of pressing is less than 250· ; and
e. The adhesion between resin and copper and woven cloth is enhanced on addition of silane.

As the description mentioned above, the performance of the said circuit boards is quite good, but there are some drawbacks to be improved as follows:
1. Even if silane is added, its peeling strength is very poor;
2. Both the absorbance of water and toluene are still too high;
3. The proportion of filler is over 50 wt%, even up to 70 wt% then it is difficult to be impregnated with the current equipment, and the wearing of a drill head during drilling is too much.

In addition to US Patents, there are other literatures relating the application of polybutadiene on circuit board material, For example, a novel 1,2-polybutadiene flame retardant substrate material described in N. Sawatari et al., IEEE Transactions on Electrical Insulation, Vol. EI-18, No. 2, Apr. 1983 shows the handling of 1,2-polybutadiene at semi-hardening stage (B stage) is difficult, it is very hard to be sticky free, also easy to be burned and the adhesion with copper foil is poor. In order to solve these problems, some ways are proposed in the said literature: to use a lot of high molecular weight polybutadiene to eliminate the stickiness in B stage, and to add a small amount of modified low molecular weight polybutadiene resin to facilitate the flow during copper foil laminating. But no usage of any type of filler is mentioned.

In EU 0202488 A2, a polybutadiene-based circuit board is revealed; wherein a high molecular weight brominated prepolymer is blended to reduce the stickiness of polybutadiene substrate and flammability. On the other hand, JP-04 258,658 reveals the incorporation of a high molecular compound to control the stickiness, while the main function of the compound is to provide flame retardant, better adhesion to copper and heat resistance. No other filler is described, and the circuit board still has the disadvantage of a high dissipation factor.

In the "High performance of 1,2-polybutadine resin of Electrical Industry" by R. E. Drake, ANTEC 84 pp. 730-733, 1984, it is clearly reported that the traditional polybutadiene resin is used as PCB substrate, and that a reactive monomer reacts with the polybutadiene and cures together. In U.K. Patent Application No. 2172892, it is described that a circuit board is made from the thermoplastic copolymer of unsaturated double bond containing styrene and polybutadiene.

The present invention relates to a polybutadiene-based PCB substrate with improved electric, chemical and heat resistance properties as compared to the related arts. The object of the present invention is to provide a novel polybutadiene-based PCB substrate with better heat resistance, thermo expansion coefficient, dielectric constant, dissipation factor, no stickiness, adhesion strength, and the present invention also provides a novel circuit board composition of polybutadiene thermosetting resin and the manufacturing process thereof.

The first object of the present invention is to provide a lot of unsaturated vinyl groups for a crosslinking reaction to form a superior heat resistance of circuit board composition.

The second object is to provide a suitable amount and kind of fillers to form a circuit board composite with low stickiness, easy lamination, and good electric properties, such as low dielectric constant and dissipation factor.

The third object of the present invention is to provide a circuit board composite which can reach a peeling strength with a ordinary copper foil over 4 Ibf/inch.

The fourth object of the present invention is to provide a circuit board composite with a lower hygroscopic property than a common CCL (copper clad laminate).

The fifth object of the present invention is to provide a low temperature (170-220· ) substrate hot pressing process which can avoid a brominated flame retardant agent to be decomposed to deteriorate the heat resistance of circuit substrate.

### DETAILED DESCRIPTION OF THE PREFERRED EMBODIMENT:

This invention provides a novel polybutadiene circuit board composition including:
20-35 wt% of resins which comprises a polybutadiene polymer resin with a high vinyl group content (more than 70 wt%.) and MW equal or more than 100,000 g/mol, and a low molecular weight polybutadiene (MW=5,000∼10,000 g/mol), and a kind of cycloolefin compound with at least two vinyl group, and/or a terpolymer made from acrylic acid, acrylonitrile and butadiene;
10-30 wt% of woven glass fiber reinforced cloth;
25-50 wt% of particulate filler, which is preferably, fused silica;
10-30 wt% of a brominated flame retardant (for better flame retardant);
1-10 wt% of metallic coagents (for elevating the peeling strength between resin and metal); and

A peroxide initiator.

The composition of the present invention contains a high vinyl polybutadiene thermosetting resin. The content of 1,2-addition vinyl group is more than 85 % in the resin composition, which provide a lot of unsaturated vinyl groups for crosslinking reaction and forming the highest crosslinking density after curing. Thus it can give circuit boards having a superior heat resistance.

Another technology characteristic of the present invention is in that the formulation is obtained from suitably selecting the dose and the type of fillers to let the varnish viscosity not too high to be impregnated, and after semi-curing, there is almost no stickiness between prepreg, thus it is easy to laminate and to improve Z-axis thermal expansion coefficient and dielectric properties (such as dissipation factor), to cut the production cost. The most important one is that it can be applied in the current board hot pressing process, and use the pressing process at a lower temperature.

In addition to above technology features, the most important features of the present invention lie on:
1. The incorporation of 1 to 10 wt% of metallic coagents can increase the peeling strength of resin and metal, i.e. the target of the elevation of the adhesion strength between resin and metal can be achieved.
2. The curing temperature during hot pressing is as low as 170-220· . Such a low curing temperature can avoid the degradation of brominated flame retardant, and can be applied in the traditional circuit substrate process equipment. Further more, a suitable amount of organic peroxides; such as dicumyl peroxide (DCP) and t-butyl perbenzoate peroxide (TBPB) can be used at a lower curing temperature.

### EXAMPLES:

Base resins, fillers, metallic coagents, crosslinking agents, glass fiber cloth, flame retardant agents and peroxide curing initiators will be used in the present invention, and the sources thereof are described sequentially as follows:

### I . Base resins:

The base resin used in the present invention is a thermosetting resin composition which comprises (1) polybutadiene resin; and (2) a kind of cycloolefin compound with at least two vinyl group, and/or (3) a terpolymer obtained from the polymerization of acrylic acid, acrylonitrile, butadiene, which can take part in crosslinking reaction during curing, wherein (1) polybutadiene resin may be a solid or liquid at the room temperature, but it should be a blend of a high molecular weight (MW• • 100,000 g/mol) solid resin and a low molecular weight (MW=5,000 ∼ 10,000 g/mol) liquid resin, and its 1,2-addition vinyl group content is above 70 wt%, preferably above 90 wt%. The high vinyl containing polybutadiene resin can give a lot of unsaturated vinyl groups for crosslinking, thus can increase crosslinking density, and thereby can result in superior high temperature resistance.

The preferable high molecular weight resins are RB series resins, such as RB810, RB820 and RB830, and more than 90 wt% 1,2-addition polybutadiene solid resin. RB series resins are available from Japan Synthetic Rubber Corp. Low molecular liquid resins, such as Ricon153 and Ricon154 resins (Sartomer Corp.) or B3000 and B1000 resins (Nippon Soda Corp.) are preferable.

Another kind of thermosetting resins (2) includes cycloolefin compound with at least two vinyl group and/or a terpolymer made from acrylic acid, acrylonitrile and butadiene, wherein cycloolefin compound with at least two vinyl double bonds can undergo cross linking reaction via vinyl double bonds, and cycloolefin in the molecular chain can suppress hygroscopic, dielectric constant and dissipation factor, such cycloolefin copolymer are produced from the reaction of ethylene, norbornene, ethylidene norbornene monomers etc. with a metallocene catalyst.
1. Synthesis of cycloolefin copolymer• COC-A• :
   4.01 kg of high purity NB (norbornene), 2.27 kg of ENB (5-Ethylidene- 2-norbornene) and 2.59 kg of toluene are introduced into a high pressure reactor, heated up to 100• ; then 0.2 kg of 10 wt% of cocatalyst (MAO/toluene) and 6×10⁻⁵ kg of metallocene catalyst are injected, the mixed gases of ethylene (800 ml/min) and hydrogen (50 ml/min) are introduced to conduct polymerization under a pressure of 18 kg/cm². After reaction is completed, toluene is added to dilute the solid content to below 10 wt%, hydrochloric acid is used for neutralization, then filtrate is added into large amount of acetone, cycloolefin copolymer (COC-A) is precipitated as solid and dried in oven,
   W=41,000 g/mol, Tg=125• :
2. Synthesis of cycloolefin copolymer (COC-B):
   Butyl-NB is obtained from the reaction of adding DCPD to 1-hexene. 2 kg of high purity Butyl-NB, 1 kg of NB (norbornene), 2 kg of ENB (5-etheylidene-2-norbornrene) and 1 kg of toluene are incorporated into a high pressure reactor, heated to 100• ; 0.08 kg of cocatalyst (MAO/toluene, 10 wt%) and 2×10⁻⁵ kg of metallocene catalyst are added, then the mixed gases of ethylene (800 ml/min) and hydrogen (50 ml/min) are introduced to conduct polymerization under a pressure of 10 kg/cm². After reaction is completed, toluene is added to dilute the solid content to below 10 wt%, hydrochloric acid is used for neutralization, then filtrate is added into large amount of acetone, cycloolefin copolymer (COC-B) is precipitated as solid and dried in oven,
   • W=66,000 g/mol, Tg=123• • •
3. Synthesis of cycloolefin copolymer (COC-C):
   Hexyl-NB with long chain is obtained from the reaction of adding DCPD to 1-octene. 2 kg of a high purity Hexyl-NB, 2.8 kg of ENB (5-otheylidene-2-norbornene), and 1 kg of toluene are incorporated into a high pressure reactor, heated to 100• ; 0.08 kg of cocatalyst (MAO/toluene, 10 wt%) and 2×10⁻⁵ kg of metallocene catalyst are added, then the mixed gases of ethylene (800 ml/min) and hydrogen (50 ml/min) a re introduced to conduct polymerization under a pressure of 10kg/cm². After reaction is completed, toluene is added to dilute the solid content to below 10 wt%, hydrochloric acid is used for neutralization, then filtrate is added into large amount of acetone, cycloolefin copolymer (COC-C) is precipitated as solid and dried in oven,
   MW=70,500 g/mol, Tg=107• • •

In addition, another resin (3) resulted from the polymerization of acrylic acid; acrylonitrile and butadiene can be used to improve the adhesion strength between resin and copper foil. Examples of these resins are Carboxyl terminated butadiene acrylonitrile rubber series (such as CTBN1300x8, CTBN1300×13, CTBN1300×31) available from Noveon Corp.

### II. Particulate fillers

The particulate fillers used in the present invention are titanium dioxide, barium titanate, strontium titanate, silica (including amorphous silica and fused silica); the dose thereof is 25-50 %, preferably 30-45 % of the weight of total composition.

They can be used alone or in a mixture thereof. The best filler is amorphous silica, preferably chosen from those with a high surface area, e.g. fused silica. As compared with normal amorphous silica (generally, 10 µm), those with a high surface area can reduce stickiness more efficiently. Among them, fused silica, e.g. AEROSIL200 of Degussa Corp. is preferable, which is characterized in 200 m²/g of specific surface area and 12 nm of particle size.

The examples of these fillers include E441 (10micron amorphous Silica, CE Minerals), FB-35 (Fused Silica, Denka), Minsil 5 (Fused Silica, Minco), Min-sil 20 (Fused Silica, Minco), Nnvacite 325 (Natural crystalline silica, Minerals), GP71 (Fused Silica, Harbison Walker).

### III. Metallic coagent

The metallic coagents used in the present invention are the complex compounds made from the reaction of alkaline metals, alkaline earth metals or zinc element and acrylic acid; generally these reagents are metallic diacrylate (e.g. SR633, SR636, SR638, SR705, SR706), metallic dimethacrylate (e.g. SR634, SR708), and metallic monomethacrylate (SR709) etc. which are available from Sartomer Corp.

During the hot curing process, firstly a metallic coagent with higher reactivity can react with a peroxide curing initiator to form a free radical containing compound, then conduct a crosslinking reaction with polybutadiene resin or other double bond containing resins, thereby every molecular chain possesses acrylate, thus enhance the peeling strength between resin and metal, i.e. improve the adhesion strength of resin and copper foil.

### IV. Crosslinking agent

The crosslinking agents for increasing the degree of crosslinking include triallyl cyanurate, triallyl isocyanurate, diallyl phthalate, divinylbenzene or the mixture thereof.

### V. Glass fiber cloth

The glass fiber cloth content is 10-30 wt% of the total composition, the glass fiber cloth made by NAN YA Plastic Corp. is used as a reinforcing material, and the specifications of glass fiber cloth depend on the application of boards as follows:

| Cloth | Base weight | Thickness | Structure (inch) | |
|---|---|---|---|---|
| -- | (g/m²) | (mm) | warp | woof |
| 7628 | 208 | 0.18 | 44 | 33 |
| 2116 | 105 | 0.19 | 60 | 58 |
| 1080 | 48 | 0.055 | 60 | 48 |
| 106 | 24 | 0.04 | 56 | 56 |

### VI. Flame retardant

The flame retardant agents used in the present invention are mainly bromine-based flame retardant agents. The dose thereof is 10-30 wt%. The preferable bromine-based flame retardant agents are for example Saytex BT-93W (ethylene bistetrabromophthalimide), Saytex 120 (tetradecabromo-diphenoxy benzene) or Saytex 102 (decabromodiphenoxy oxide).

### VII. Initiators

A free radical initiator is added to accelerate a crosslinking reaction. The said initiator will be decomposed to form free radical, thereby initiates a crosslinking polymerization. The preferable free radical initiators are e.g. organic peroxides, such as dicumyl peroxide (DCP), t-butylperbenzoate (TBPB) and t-butylperoxy hexyne-3. These are commonly used hardening agents, and the dose thereof is 0.2-3 wt%.

### Examples:

In addition to above-mentioned three cycloolefin copolymers, the other are listed in the following table:

The material specifications & sources of the circuit board composition

| Suppliers | Trade names | Description |
|---|---|---|
| JSR | RB810 | 1,2-addition Polybutadiene Rubber MW=140,000 g/mol, vinyl=90 % |
| SARTOMER | Ricon154 | 1,2-addition Polybutadiene Rubber MW=52,000 g/mol, vinyl=91 % |
| SARTOMER | Ricon153 | 1,2-addition Polybutadiene Rubber MW=47,000 g/mol, vinyl=85 % |
| DENKA | FB-35 | Fused Silica |
| ALBEMARLE | SAYTRX8010 | Br-flame retardant, Br=82 % |
| ACROS | TAIC | Triallyl isocyanurate |
| LAPORTE | DCP | Dicumyl peroxide |
| SARTOMER | SARET633 | Zinc diacrylate |
| NAN YA | 1080woven glass | Thickness=0.05 mm, base weight= 48 g/m² |

### Example 1:

104.3 parts by weight of a high molecular weight polybutadiene rubber (RB810), 63.6 parts by weight of low molecular weight polybutadiene rubber (Ricon154), 85.9 parts by weight of cycloolefin copolymer (COC-A) and 12.5 parts by weight of CTBN1300×8 are homogeneously mixed; then 13.3 parts by weight of SARET 633, 429.5 parts by weight of silica filler (FB-35), 163.2 parts by weight of brominated flame retardant (SAYTEX8010), 8 parts by weight of cross linking agent (TAIC), 8 parts by weight of hardening initiator (DCP) are added and homogeneously agitated, hereafter 111.7 parts by weight of woven glass (#1080) is impregnated in the resultant liquid, and at 130• ; they are semi-hardened to form a prepreg, 8 sheets of prepreg are laminated and sandwiched in 2 copper foils (NAN YA's 1 oz), the resulted composite is hot pressed under the condition of 30 kg/cm² (426 psi), 195• •for 3 hours to become a circuit board composite, the tested physical properties are listed in Table 1.

### Example 2

The dose of COC-A is increased to replace part of RB810, in other words, 61.3 parts by weight of PB810, 636 parts by weight of Ricon154 are mixed, then 128.9 parts by weight of COC-A and 12.5 parts by weight of CTBN1300×8 are added and homogeneously mixed; 13.3 parts by weight of SARET 633 and 429.5 parts by weight of FB-35 filler, then 163.2 parts by weight of SAYTEX8010 and 8 parts by weight of TAIC, 8 parts by weight of DCP are incorporated and mixed homogeneously, 111.7 parts by weight of 1080 woven glass is impregnated therein, and at 130• ; they are semi- hardened to form a prepreg, 8 sheets of prepreg are laminated and sandwiched in 2 NAN YA's 1 oz copper foils, the resulted composite is hot-pressed under the condition of 30 kg/cm² (426 psi), 195• •for 3 hours to obtain a circuit board composite, the tested physical properties are listed in Table 1.

### Example 3

The dose of COC-A is decreased, while the dose of RB810 is increased, in other words, 147.2 parts by weight of RB810, 63.6 parts by weight of Ricon154, 43.0 parts by weight of COC-A and 12.5 parts by weight of CTBN1300×8 are homogeneously mixed; then 13.3 parts by weight of SARET 633, 429.5 parts by weight of FB-35 filler, 163.2 parts by weight of SAYTEX8010, 8 parts by weight of TAIC, 8 parts by weight of DCP are added sequentially, and mixed homogeneously, 111.7 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 1.

### Example 4

Ricon154 resin is substituted by Ricon153, in the other words, 104.3 parts by weight of RB810, 63.6 parts by weight of Ricon153, 85.9 parts by weight of COC-A and 12.5 parts by weight of CTBN1300×8 are mixed homogeneously; then 13.3 parts by weight of SARET 633, 429.5 parts by weight of FB-35 filler, 163.2 parts by weight of SAYTEX8010, 8 parts by weight of TAIC, 8 parts by weight of DCP are added sequentially, and mixed homogeneously, 111.7 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 1.

### Comparative example 1

No SARET 633 is added. 105.7 parts by weight of RB810, 64.6 parts by weight of Ricon154, 87.1 parts by weight of COC-A and 12.6 parts by weight of CTBN1300×8 are mixed homogeneously; 435.3 parts by weight of FB-35 filler, 165.4 parts by weight of SAYTEX8010, 8.1 parts by weight of TAIC and 8.1 parts by weight of DCP are added sequentially, and mixed homogeneously, 113.2 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 1.

### Comparative example 2

Ricon153 is used to replace RB810 resin, i.e. 104.3 parts by weight of Ricon153, 85.9 parts by weight of COC-A and 12.5 parts by weight of CTBN1300x8 are mixed homogeneously; then 13.3 parts by weight of SARET633, 429.5 parts by weight of FB-35 filler, 163.2 parts by weight of SAYTEX8010, 8 parts by weight of TAIC and 8 parts by weight of DCP are added sequentially, and mixed homogeneously, 111.7 parts by weight of 1080 woven glass is impregnated therein and at 130• ; they a re semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 1.

**Table 1**

| Composition | Examples | | | | Comparative Examples | |
|---|---|---|---|---|---|---|
| Material parts by weight | 1 | 2 | 3 | 4 | 1 | 2 |
| RB810 | 104.3 | 61.3 | 147.2 | 104.3 | 105.7 | 0.0 |
| Ricon154 | 63.6 | 63.6 | 63.6 | 0.0 | 64.5 | 63.6 |
| Ricon153 | 0.0 | 0.0 | 0.0 | 63.6 | 0.0 | 104.3 |
| COC-A | 85.9 | 128.9 | 43.0 | 85.9 | 87.1 | 85.9 |
| CTBN1300×8 | 12.5 | 12.5 | 12.5 | 12.5 | 12.6 | 12.5 |
| FB-35 | 429.5 | 429.5 | 429.5 | 429.5 | 435.3 | 429.5 |
| 1080 woven glass | 111.7 | 111.7 | 111.7 | 111.7 | 113.2 | 111.7 |
| SAYTRX8010 | 163.2 | 163.2 | 163.2 | 163.2 | 165.4 | 163.2 |
| TAIC | 8.0 | 8.0 | 8.0 | 8.0 | 8.1 | 8.0 |
| SARET633 | 13.3 | 13.3 | 13.3 | 13.3 | 0.0 | 13.3 |
| DCP | 8.0 | 8.0 | 8.0 | 8.0 | 8.1 | 8.0 |

| Tested Data | | | | | | |
|---|---|---|---|---|---|---|
| Items/data board | 1 | 2 | 3 | 4 | 1 | 2 |
| Peeling strength (Ibf/inch) | 4.34 | 4.65 | 4.02 | 4.21 | 1.41 | 2.65 |
| Dielectric constant DK | 2.95 | 2.91 | 2.99 | 2.93 | 2.97 | 3.01 |
| Dissipation factor DF | 0.0011 | 0.0009 | 0.0011 | 0.0010 | 0.0011 | 0.0015 |
| Hygroscopic (wt%) | 0.24 | 0.21 | 0.26 | 0.25 | 0.25 | 0.23 |
| Soldering resistance (second) | 300 above | 300 above | 300 above | 250.0 | 300 above | 15 |
| Flame retardant UL-94 | V-0 | V-0 | V-0 | V-0 | V-0 | V-0 |

### Physical properties analysis:

Increasing of COC-A dose can raise peeling strength slightly and decrease hygroscopic (moisture absorbance); if the low molecular weight polybutadiene rubber Ricon153 (molecular weight MW < 5,000) is used to replace Ricon154 resin, there is no significant effect shown, but if RB810 (MW > 5,000) is substituted, the peeling strength is deteriorated, and the heat resistance at tin welding is obviously not enough. As shown in Table 1, the incorporation of SARET633 (the dose thereof is 5 phr of the thermosetting resin) can improve the peeling strength, in other words, if SARET633 is not added, the peeling strength becomes worse.

### Example 5

The dose of fillers is reduced. 141.5 parts by weight of RB810, 75.9 parts by weight of Ricon154, 85.4 parts by weight of COC-A and 14.9 parts by weight of CTBN1300x8 are mixed homogeneously; then 15.9 parts by weight of SARET 633, 341.6 parts by weight of FB-35 filler, 194.7 parts by weight of SAYTEX8010, 9.5 parts by weight of TAIC and 9.5 parts by weight of DCP are added sequentially, and mixed homogeneously, 111.0 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 2.

### Example 6

The dose of COC-A is elevated to replace part of RB810, i.e. 98.8 parts by weight of RB810, 75.9 parts by weight of Ricon154, 128.1 parts by weight of COC-A and 14.9 parts by weight of CTBN1300×8 are mixed homogeneously; then 15.9 parts by weight of SARET633, 341.6 parts by weight of FB-35 filler, 194.7 parts by weight of SAYTEX8010, 9.5 parts by weight of TAIC and 9.5 parts by weight of DCP are added sequentially, and mixed homogeneously, 111.0 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 2.

### Example 7

The dose of COC-A is reduced and replaced by increasing RB810 content, i.e. 184.2 parts by weight of RB810, 75.9 parts by weight of Ricon154, 42.7 parts by weight of COC-A and 14.9 parts by weight of CTBN1300×8 are agitated homogeneously; then 15.9 parts by weight of SARET633, 341.6 parts by weight of FB-35 filler and 194.7 parts by weight of SAYTEX8010, 9.5 parts by weight of TAIC and 9.5 parts by weight of DCP are added sequentially, and mixed homogeneously, 111.0 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 2.

### Example 8

Ricon153 resin is used to replace Ricon154 resin, i.e. 141.5 parts by weight of RB810, 75.9 parts by weight of Ricon153, 85.4 parts by weight of COC-A, 14.9 parts by weight of CTBN1300x8 are agitated homogeneously; then 15.9 parts by weight of SARET 633, 341,6 parts by weight of FB-35 filler, 194.7 parts by weight of SAYTEX8010, 9.5 parts by weight of TAIC and 9.5 parts by weight of DCP are added sequentially, and mixed homogeneously, 111.0 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• • for 3 hours to obtain a circuit substrate composite, the tested physical properties thereof are listed in Table 2.

### Comparative example 3

No SARET 633 is added. 143.8 parts by weight of RB810, 77.1 parts by weight of Ricon154, 86.8 parts by weight of COC-A and 15.1 CTBN1300×8 are agitated homogeneously; then 347.1 parts by weight of FB-35 filler, 197.9 parts by weight of SAYTEX8010, 9.7 parts by weight of TAIC and 9.7 parts by weight of DCP are added sequentially, and mixed homogeneously, 112.8 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 2.

### Comparative example 4

Following the same steps as Example 5, but Ricon153 is used to replace RB810.

### Comparative example 5

The dose of fillers is reduced 25 wt%, and the brominated flame retardant agent content is raised to meet the requirement of flame retardant of circuit board substrate. 164.1 parts by weight of RB810, 88.1 parts by weight of Ricon154, 99.0 parts by weight of COC-A and 16.6 parts by weight of CTBN1300×8 are agitated homogeneously; then 18.4 parts by weight of SARET633, 254.7 parts by weight of FB-35 filler, 225.5 parts by weight of SAYTEX8010, 11.1 parts by weight of TAIC and 11.1 parts by weight of DCP are added sequentially, and mixed homogeneously, 111.0 parts by weight of 1080 woven glass is impregnated therein and at 130• ; they are semi-hardened to form a prepreg. 8 sheets of prepreg are laminated, and sandwiched in 2 NAN YA's 1 oz copper foils, then hot-pressed under the condition of 30 kg/cm² (426 psi), 195• •for 3 hours to obtain a circuit board composite, the tested physical properties are listed in Table 2.

**Table 2**

| Composition | Examples | | | | Comparative examples | | |
|---|---|---|---|---|---|---|---|
| Material parts by weight | 5 | 6 | 7 | 8 | 3 | 4 | 5 |
| RB810 | 141.5 | 98.8 | 184.2 | 141.5 | 143.8 | 0.0 | 164.1 |
| Ricon154 | 75.9 | 75.9 | 75.9 | 0.0 | 77.1 | 75.9 | 88.1 |
| Ricon153 | 0.0 | 0.0 | 0.0 | 75.9 | 0.0 | 141.5 | 0.0 |
| COC-A | 85.4 | 128.1 | 42.7 | 85.4 | 86.8 | 85.4 | 99.0 |
| CTBN1300x8 | 14.9 | 14.9 | 14.9 | 14.9 | 15.1 | 14.9 | 16.6 |
| FB-35 | 341.6 | 341.6 | 341.6 | 341.6 | 347.1 | 341.6 | 254.7 |
| 1080 woven glass | 111.0 | 111.0 | 111.0 | 111.0 | 197.9 | 111.0 | 111.0 |
| SAYTEX8010 | 194.7 | 194.7 | 194.7 | 194.7 | 197.9 | 194.7 | 225.9 |
| TAIC | 9.5 | 9.5 | 9.5 | 9.5 | 9.7 | 9.5 | 11.1 |
| SARET 633 | 15.9 | 15.9 | 15.9 | 15.9 | 0.0 | 15.9 | 18.4 |
| DCP | 9.5 | 9.5 | 9.5 | 9.5 | 9.7 | 9.5 | 11.1 |

| Tested Data | | | | | | | |
|---|---|---|---|---|---|---|---|
| Items/data | 5 | 6 | 7 | 8 | 3 | 4 | 5 |
| Peeling strength (Ibf/inch) | 5.46 | 5.87 | 5.18 | 5.33 | 1.65 | 4.87 | 6.18 |
| Dielectric constant DK | 2.82 | 2.78 | 2.81 | 2.83 | 2.84 | 2.85 | 2.80 |
| Dissipation factor DF | 0.0007 | 0.0007 | 0.0008 | 0.0008 | 0.0009 | 0.0010 | 0.0008 |
| Hygroscopic (wt%) | 0.27 | 0.24 | 0.28 | 0.28 | 0.27 | 0.26 | 0.30 |
| Soldering resistance | 300 | 300 | 300 | 220 | 300 | 10 | 10 |
| (second) | above | above | above | | above | | |
| Flame retardant UL-94 | V-0 | V-0 | V-0 | V-0 | V-0 | V-0 | V-1 |

### Physical properties analysis:

To raise the contents of thermosetting resin and SARET633 (the amount used is 5 phr of thermosetting resin) can improve the peeling strength and lower the dielectric constant; but if the filler content is under 30 wt% of total composition, both heat resistance and flame retardant become worse.

### Examples 9-16

Following the steps of Example 1-8, the only difference is that COC-A is replaced by COC-B; the tested physical properties of circuit board composite are listed in Tables 3 & 4.

### Comparative examples 6-10

Following the steps of Comparative example 1-5, the only difference is that COC-A is replaced by COC-B; the tested physical properties of circuit board composite are listed in Tables 3 & 4.

**Table 3**

| Composition | Examples | | | | Comparative examples | |
|---|---|---|---|---|---|---|
| Material parts by weight | 9 | 10 | 11 | 12 | 6 | 7 |
| RB810 | 104.3 | 61.3 | 147.2 | 104.3 | 105.7 | 0.0 |
| Ricon154 | 63.6 | 63.6 | 63.6 | 0.0 | 64.5 | 63.6 |
| Ricon153 | 0.0 | 0.0 | 0.0 | 63.6 | 0.0 | 104.3 |
| COC-B | 85.9 | 128.9 | 43.0 | 85.9 | 87.1 | 85.9 |
| CTBN1300×8 | 12.5 | 12.5 | 12.5 | 12.5 | 12.6 | 12.5 |
| FB-35 | 429.5 | 429.5 | 429.5 | 429.5 | 435.3 | 429.5 |
| 1080 woven glass | 111.7 | 111.7 | 111.7 | 111.7 | 113.2 | 111.7 |
| SAYTRX8010 | 163.2 | 163.2 | 163.2 | 163.2 | 165.4 | 163.2 |
| TAIC | 8.0 | 8.0 | 8.0 | 8.0 | 8.1 | 8.0 |
| SARET633 | 13.3 | 13.3 | 13.3 | 13.3 | 0.0 | 13.3 |
| DCP | 8.0 | 8.0 | 8.0 | 8.0 | 8.1 | 8.0 |

| Tested data | | | | | | |
|---|---|---|---|---|---|---|
| Items/data | 9 | 10 | 11 | 12 | 6 | 7 |
| Peeling strength (Ibf/inch) | 4.14 | 4.46 | 3.89 | 4.06 | 1.18 | 2.28 |
| Dielectric constant DK | 2.96 | 2.93 | 2.97 | 2.94 | 2.98 | 3.01 |
| Dissipation factor DF | 0.0010 | 0.0009 | 0.0011 | 0.0011 | 0.0010 | 0.0014 |
| Hygroscopic (wt%) | 0.27 | 0.25 | 0.29 | 0.30 | 0.28 | 0.27 |
| Soldering resistance (second) | 300 above | 300 above | 300 above | 270.0 | 300 above | 25 |
| Flame retardant UL-94 | V-0 | V-0 | V-0 | V-0 | V-0 | V-0 |

**TABLE 4**

| Composition | Examples | | | | Comparative examples | | |
|---|---|---|---|---|---|---|---|
| Material parts by weight | 13 | 14 | 15 | 16 | 8 | 9 | 10 |
| RB810 | 141.5 | 98.8 | 184.2 | 141.5 | 143.8 | 0.0 | 164.1 |
| Ricon154 | 75.9 | 75.9 | 75.9 | 0.0 | 77.1 | 75.9 | 88.1 |
| Ricon153 | 0.0 | 0.0 | 0.0 | 75.9 | 0.0 | 141.5 | 0.0 |
| COC-B | 85.4 | 128.1 | 42.7 | 85.4 | 86.8 | 85.4 | 99.0 |
| CTBN1300×8 | 14.9 | 14.9 | 14.9 | 14.9 | 15.1 | 14.9 | 16.6 |
| FB-35 | 341.6 | 341.6 | 341.6 | 341.6 | 347.1 | 341.6 | 254.7 |
| 1080 woven glass | 111.0 | 111.0 | 111.0 | 111.0 | 197.9 | 111.0 | 111.0 |
| SAYTEX8010 | 194.7 | 194.7 | 194.7 | 194.7 | 197.9 | 194.7 | 225.9 |
| TAIC | 9.5 | 9.5 | 9.5 | 9.5 | 9.7 | 9.5 | 11.1 |
| SARET 633 | 15.9 | 15.9 | 15.9 | 15.9 | 0.0 | 15.9 | 18.4 |
| DCP | 9.5 | 9.5 | 9.5 | 9.5 | 9.7 | 9.5 | 11.1 |

| Tested data | | | | | | | |
|---|---|---|---|---|---|---|---|
| Items/data | 13 | 14 | 15 | 16 | 8 | 9 | 10 |
| Peeling strength (Ibf/inch) | 5.39 | 5.72 | 5.01 | 5.12 | 1.48 | 4.59 | 5.88 |
| Dielectric constant DK | 2.84 | 2.80 | 2.82 | 2.83 | 2.85 | 2.87 | 2.81 |
| Dissipation factor DF | 0.0008 | 0.0007 | 0.0009 | 0.0008 | 0.0010 | 0.0011 | 0.0009 |
| Hygroscopic (wt%) | 0.31 | 0.28 | 0.32 | 0.33 | 0.32 | 0.30 | 0.37 |
| Soldering resistance (second) | 300 above | 300 above | 300 above | 235 | 300 above | 40 | 30 |
| Flame retardant UL-94 | V-0 | V-0 | V-0 | V-0 | V-0 | V-0 | V-1 |

### Examples 17-24

Following the steps of Example 1-8, the only difference is that COC-A is replaced by COC-C; the tested physical properties of circuit board composite are listed in Tables 5 & 6.

### Comparative examples 11-15

Following the steps of Comparative example 1-5, the only difference is that COC-A is replaced by COC-C; the tested physical properties of circuit board composite are listed in Tables 5 & 6.

**Table 5**

| Compose | Examples | | | | Comparative examples | |
|---|---|---|---|---|---|---|
| Material parts by weight | 17 | 18 | 19 | 20 | 11 | 12 |
| RB810 | 104.3 | 61.3 | 147.2 | 104.3 | 105.7 | 0.0 |
| Ricon154 | 63.6 | 63.6 | 63.6 | 0.0 | 64.5 | 63.6 |
| Ricon153 | 0.0 | 0.0 | 0.0 | 63.6 | 0.0 | 104.3 |
| COC-C | 85.9 | 128.9 | 43.0 | 85.9 | 87.1 | 85.9 |
| CTBN1300×8 | 12.5 | 12.5 | 12.5 | 12.5 | 12.6 | 12.5 |
| FB-35 | 429.5 | 429.5 | 429.5 | 429.5 | 435.3 | 429.5 |
| 1080 woven glass | 111.7 | 111.7 | 111.7 | 111.7 | 113.2 | 111.7 |
| SAYTRX8010 | 163.2 | 163.2 | 163.2 | 163.2 | 165.4 | 163.2 |
| TAIC | 8.0 | 8.0 | 8.0 | 8.0 | 8.1 | 8.0 |
| SARET633 | 13.3 | 13.3 | 13.3 | 13.3 | 0.0 | 13.3 |
| DCP | 8.0 | 8.0 | 8.0 | 8.0 | 8.1 | 8.0 |

| Tested data | | | | | | |
|---|---|---|---|---|---|---|
| Items/data | 17 | 18 | 19 | 20 | 11 | 12 |
| Peeling strength (Ibf/inch) | 4.08 | 4.25 | 3.81 | 3.92 | 1.05 | 2.16 |
| Dielectric constant DK | 2.94 | 2.91 | 2.95 | 2.93 | 2.96 | 3.02 |
| Dissipation factor DF | 0.0011 | 0.0010 | 0.0012 | 0.0011 | 0.0010 | 0.0013 |
| Hygroscopic (wt%) | 0.30 | 0.28 | 0.31 | 0.32 | 0.30 | 0.31 |
| Soldering resistance | 300 | 300 | 300 | 285.0 | 300 | 40 |
| (second) | above | above | above | | above | |
| Flame retardant UL-94 | V-0 | V-0 | V-0 | V-0 | V-0 | V-0 |

**Table 6**

| Composition | Examples | | | | Comparative examples | | |
|---|---|---|---|---|---|---|---|
| Material parts by weight | 21 | 22 | 23 | 24 | 13 | 14 | 15 |
| RB810 | 141.5 | 98.8 | 184.2 | 141.5 | 143.8 | 0.0 | 164.1 |
| Ricon154 | 75.9 | 75.9 | 75.9 | 0.0 | 77.1 | 75.9 | 88.1 |
| Ricon153 | 0.0 | 0.0 | 0.0 | 75.9 | 0.0 | 141.5 | 0.0 |
| COC-• • | 85.4 | 128.1 | 42.7 | 85.4 | 86.8 | 85.4 | 99.0 |
| CTBN1300×8 | 14.9 | 14.9 | 14.9 | 14.9 | 15.1 | 14.9 | 16.6 |
| FB-35 | 341.6 | 341.6 | 341.6 | 341.6 | 347.1 | 341.6 | 254.7 |
| 1080 woven glass | 111.0 | 111.0 | 111.0 | 111.0 | 112.8 | 111.0 | 111.0 |
| SAYTEX8010 | 194.7 | 194.7 | 194.7 | 194.7 | 197.9 | 194.7 | 225.9 |
| TAIC | 9.5 | 9.5 | 9.5 | 9.5 | 9.7 | 9.5 | 11.1 |
| SARET 633 | 15.9 | 15.9 | 15.9 | 15.9 | 0.0 | 15.9 | 18.4 |
| DCP | 9.5 | 9.5 | 9.5 | 9.5 | 9.7 | 9.5 | 11.1 |

| Tested data | | | | | | | |
|---|---|---|---|---|---|---|---|
| Items/data | 21 | 22 | 23 | 24 | 13 | 14 | 15 |
| Peeling strength (Ibf/inch) | 5.21 | 5.65 | 4.96 | 5.01 | 1.35 | 4.46 | 5.75 |
| Dielectric constant DK | 2.83 | 2.79 | 2.81 | 2.82 | 2.83 | 2.86 | 2.79 |
| Dissipation factor DF | 0.0009 | 0.0007 | 0.0009 | 0.0100 | 0.0008 | 0.0010 | 0.0009 |
| Hygroscopic (wt%) | 0.33 | 0.31 | 0.34 | 0.34 | 0.35 | 0.33 | 0.40 |
| Soldering resistance (second) | 300 above | 300 above | 300 above | 250 | 300 above | 70 | 50 |
| Flame retardant UL-94 | V-0 | V-0 | V-0 | V-0 | V-0 | V-0 | V-1 |

### Physical properties analysis

The change of the kind of cycloolefin copolymer in the thermosetting composition has little effect on dielectric constant and dissipation factor, but COC-C with longer chain branching shows better toughness, more rubber-like property and superior heat resistance at tin soldering than those of COC-B, while COC-A with no chain branching is the worst. Nevertheless, the longer the chain branching of cycloolefin copolymer, results in the more the hygroscopic and the worse the peeling strength.

### THE PERFORMANCE OF THE INVENTION

According to the examples and the tested physical properties mentioned above, the following summaries are concluded:
(1) The peeling strength mainly depends on the doses of SARET633 (5 phr by weight of thermosetting resin) and cycloolefin copolymer, the higher the both dosages in the total composition, the better the peeling strength.
(2) Dielectric properties (Dk, Df) mainly depend upon the total content of thermosetting resins, the higher the content, the lower the Dk & Df, but the higher the hygroscopic (moisture absorbance).
(3) To increase the content of cycloolefin copolymer can reduce hygroscopic (moisture absorbance), but the effect is not obvious.
(4) The heat resistance at tin soldering depends on the proportion of the high molecular resin (MW > 5,000) in the thermosetting resins and the content of fillers; the proportion of the high molecular resin (e.g. RB810, COC-A, COC-B, COC-• ) should be over 15 wt%, and the content of fillers accounts over 30 wt% of total composition, i.e. the content of thermosetting resins is not over 35 wt% of total composition, then a superior heat resistance can be realized.
(5) To meet the requirement of UL-94 V-0 flame retardant mainly depends on the proportions of the brominated flame retardant and fillers. In the present invention, the brominated flame retardant agent content is controlled at around 30 wt% (without fillers and woven glass), but if fillers content is below 30 wt%, the flame retardant will deteriorate, and the prepreg has a higher stickiness, thus it is detrimental to process.

According to above statements, and as compared with a traditional copper foil laminate, the printed circuit board (PCB) in the present invention shows better electrical properties, i.e. lower dielectric constant and dissipation factor, also a lower moisture absorbance (hygroscopic).

Regarding the peeling strength, even if an ordinary copper foil is used in the present invention, the peeling strength can be up to 4 Ibf/inch, which is much better than 0.25 Ibf/inch shown in a traditional copper foil PCB substrate. In addition, the product in the present invention shows a better heat resistance, and the hot pressing temperature is only 195• ; i.e. a high temperature (over 250• ) is not necessary during curing processing, thereby results in the physical properties of PCB substrate to be extremely superior.

## Claims

1. A high performance circuit board composition, which includes:
(1) 20-35 wt% of thermosetting base resins which include:
(a) a mixture of a high vinyl content (over 70 wt%) polybutadiene thermosetting resin with a molecular weight (MW) more than 100,000 g/mol and that with a molecular weight (MW)=5,000∼10,000 g/mol, and
(b) a high molecular polymer polymerized from a cycloolefin compound with at least two vinyl groups, and/or a terpolymer made from acrylic acid, acrylonitrile and butadiene;
(2) 10-30 wt% of a woven glass fiber reinforced cloth;
(3) 25-50 wt% of inorganic particulate fillers;
(4) 1-10 wt% of a metallic coagent;
(5) 10-30 wt% of a brominated flame retardant; and
(6) a free radical initiator.

2. The circuit board composition of claim 1, wherein the content of the thermosetting base resin is preferably 25∼32 wt%.

3. The circuit board composition of claim 2, wherein the content of polybutadiene thermosetting resin is 40∼90 wt% of total thermosetting base resins.

4. The circuit board composition of claim 2, wherein the content of cycloolefin compound with at least two vinyl group and/or a terpolymer made from acrylic acid, acrylonitrile and butadiene is 10∼60 wt% of the thermosetting base resin composition.

5. The circuit board composition of claim 2, wherein the content of the thermosetting base resin of 1,2-addition vinyl group is preferable over 80 wt% of the high vinyl of polybutadiene thermosetting resin.

6. The circuit board composition of claim 3, wherein the proportion of the polybutadiene thermosetting resin with MW more than 100,000 g/mol and that with MW=5,000∼10,000 g/mol is 40:80 to 60:20.

7. The circuit board composition of claim 1, wherein the content of woven glass fiber reinforced cloth is preferably 10∼20 wt%.

8. The circuit board composition of claim 1, wherein the content of the inorganic particulate fillers is preferably 30∼45 wt%.

9. The circuit board composition of claim 1, wherein the content of the metallic coagent is preferably 1∼5wt%.

10. The metallic coagent of claim 9, wherein the metallic coagent is selected from the complexes obtained from the reaction of alkali metals, alkali earth metals or zinc element with acrylic acid.

11. The metallic coagents of claim 10, wherein the preferable one is metallic diacrylate or metallic dimethacrylate.

12. The ciruit board composition of claim 1, wherein inorganic particulate filler is selected from titanium dioxide, barium titanate, strontium titanate or silica.

13. The circuit board composition of claim 12, wherein the preferable inorganic particulate filler is selected from amorphous silica or fused silica.

14. The circuit board composition of claim 1, wherein the content of brominated flame retardant is preferably 15~25 wt%.

15. The circuit board composition of claim 14, wherein the preferable brominated flame retardant is selected from ethylene bistetrabromophthalimide, tetradecabromodiphenoxy benezene or decabromo diphenoxy oxide.

16. A process to produce a high performance circuit board composition includes diluting the following mixture to a suitable viscosity:
(1) 20~35 wt% of a thermosetting resin substrate which contains:
(a) a blend of a high vinyl content (over 70 wt%) polybutadiene with MW>100,000 g/mol and that with MW=5,000~10,000 g/mol,
(b) a high polymer produced from the polymerization of a cycloolefin compound with at least two vinyl group and/or a terpolymer made from acrylic acid, acrylonitrile and butadiene,
(2) 10~30 wt% of a woven glass fiber reinforced cloth;
(3) 25~50 wt% of inorganic particulate fillers;
(4) 1~10 wt% of metallic coagents;
(5) 10~30 wt% of a brominated flame retardant; and
(6) a free radical initiator;
and then conducting a hot pressing to become a circuit board at the temperature of 170~220°C and the pressure of 20~50 kg/cm².

17. A process of claim 16, wherein the woven glass fiber cloth is semihardened into a resin sheet, then 5-8 sheets are laminated and sandwiched by two copper foils, thereafter are hot-pressed at an optimal temperature of 195°C and the pressure of 30 kg/cm².

## Patentansprüche

1. Eine Rochleistungs-Leiterplattenzusammensetzung, die einschließt:
(1) 20 - 35 Gew.-% eines hitzehärtenden Grundharzes, das einschließt:
(a) eine Mischung eines hitzehärtenden Polybutadien-Harzes mit hohem Vinylgehalt (über 70 Gew.-%) und einem Molekulargewicht (MW) von mehr als 100000 g/mol und einem mit einem Molekulargewicht (MW) = 5000∼10000 g/mol, und
(b) ein hochmolekulares Polymer polymerisiert aus einer Cycloolefin-Verbindung mit mindestens zwei Vinylgruppen und/oder einem Terpolymer aus Acrylsäure, Acrylnitril und Butadien;
(2) 10 - 30 Ges.-% eines gewebten, glasfaserverstärkten Gewebes;
(3) 25 - 50 Gew.-% anorganische, partikuläre Füllstoffe;
(4) 1 - 10 Gew.-% eines metallischen Ko-Agens;
(5) 10 - 30 Ges.-% eines bromierten Flammschutzmittels; und
(6) einen freien Radikalstarter.

2. Die Leiterplattenzusammensetzung nach Anspruch 1, wobei der Gehalt des hitzehärtenden Grundharzes vorzugsweise 25-32 Gew.-% beträgt.

3. Die Leiterplattenzusammensetzung nach Anspruch 2, wobei der Gehalt an hitzehärtendem Polybutadien-Harz 40∼90 Gew.-% des gesamten hitzehärtenden Grundharzes beträgt.

4. Die Leiterplattenzusammensetzung nach Anspruch 2, wobei der Gehalt einer Cycloolefin-Verbindung mit mindestens zwei Vinylgruppen und/oder eines Terpolymers aus Acrylsäure, Acrylnitril und Butadien 10∼60 Ges.-% der hitzehärtenden Grundharzzusammensetzung beträgt.

5. Die Leiterplattenzusammensetzung nach Anspruch 2, wobei der Gehalt des hitzehärtenden Grundharzes an einer 1,2-Additionsvinylgruppe vorzugsweise über 80 Ges.-% des hitzehärtenden Polybutadien-Harzes mit hohem Vinylgehalt beträgt.

6. Die Leiterplattenzusammensetzung nach Anspruch 3, wobei das Verhältnis des hitzehärtenden Polybutadien-Harzes mit einem MW größer als 100000 g/mol und des mit MW = 5000∼10000 g/mol 40:80 bis 60:20 beträgt.

7. Die Leiterplattenzusammensetzung nach Anspruch 1, wobei der Gehalt von gewebtem glasfaser-verstärktem Gewebe vorzugsweise 10∼20 Ges.-% beträgt.

8. Die Leiterplattenzusammensetzung nach Anspruch 1, wobei der Gehalt des anorganischen, partikulären Füllstoffs vorzugsweise 30∼45 Gew.-% beträgt.

9. Die Leiterplattenzusammensetzung nach Anspruch 1, wobei der Gehalt des metallischen Ko-Agens vorzugsweise 1∼5 Gew.-% beträgt.

10. Das metallische Ko-Agens nach Anspruch 9, wobei das metallische Ko-Agens ausgewählt wird aus den Komplexen erhalten aus der Reaktion von Alkalimetallen, Erdalkalimetallen oder elementarem Zink mit Acrylsäure.

11. Die metallischen Ko-Agenzien nach Anspruch 10, wobei das bevorzugte metallisches Diacrylat oder metallisches Dimethacrylat ist.

12. Die Leiterplattenzusammensetzung nach Anspruch 1, wobei der anorganische, partikuläre Füllstoff ausgewählt wird aus Titandioxid, Bariumtitanat, Strontiumtitanat oder Silica.

13. Die Leiterplattenzusammensetzung nach Anspruch 12, wobei der bevorzugte anorganische, partikuläre Füllstoff ausgewählt wird aus amorphem Silica oder Quarzglas.

14. Die Leiterplattenzusammensetzung nach Anspruch 1, wobei der Gehalt an bromiertem Flammschutzmittel vorzugsweise 15∼25 Gew.-% beträgt.

15. Die Leiterplattenzusammensetzung nach Anspruch 14, wobei das bevorzugte bromierte Flammschutzmittel ausgewählt wird aus Ethylen-bis-tetrabrom-phthalimid, Tetradekabrom-diphenoxy-benzol oder Dekabromdiphenoxyoxid.

16. Ein Verfahren zur Herstellung einer Hochleistungs-Leiterplattenzusammensetzung, das das Verdünnen der folgenden Mischung:
(1) 20 - 35 Gew.-% eines hitzehärtenden Grundharzes, das enthält:
(a) eine Mischung eines hitzehärtenden Polybutadiens mit hohem Vinylgehalt (über 70 Ges.-%) und einem MW > 100000 g/mol und einem mit einem MW = 5000∼10000 g/mol, und
(b) eines hochmolekularen Polymers hergestellt durch die Polymerisation einer Cycloolefin-Verbindung mit mindestens zwei Vinylgruppen und/oder einem Terpolymer aus Acrylsäure, Acrylnitril und Butadien;
(2) 10 - 30 Ges.-% eines gewebten glasfaserverstärkten Gewebes;
(3) 25 - 50 Ges.-% anorganischer, partikulärer Füllstoffe;
(4) 1 - 10 Gew.-% von metallischen Ko-Agenzien;
(5) 10 - 30 Gew.-% eines bromierten Flammschutzmittels; und
(6) eines freien Radikalstarters;
bis zu einer geeigneten Viskosität und dann das Durchführen einer Heißverpressung bei einer Temperatur von 170∼220°C und einem Druck von 20∼50 kg/cm², um eine Leiterplatte zu werden, einschließt.

17. Das Verfahren nach Anspruch 16, wobei das gewebte Glasfasergewebe teilweise zu einem Kunstharzblatt gehärtet wird, dann 5-8 Blätter laminiert und zwischen zwei Kupferfolien eingefasst und danach bei einer optimalen Temperatur von 195°C und einem Druck von 30 kg/cm² heißverpresst wird.

## Revendications

1. Composition de carte de circuit à haute performance, qui comprend :
(1) 20 % à 35 % en poids de résines de base thermodurcissables qui comprennent :
(a) un mélange d'une résine thermodurcissable de polybutadiène à haute teneur vinylique (supérieure à 70 % en poids) une avec un poids moléculaire (MW) supérieur à 100 000 g/mol et une avec un poids moléculaire (MW) = 5000 à 10 000 g/mol, et
(b) un polymère à poids moléculaire élevé polymérisé à partir d'un composé cyclooléfinique avec au moins deux groupes vinyliques, et/ou un terpolymère préparé à partir d'acide acrylique, d'acrylonitrile et de butadiène ;
(2) 10 % à 30 % en poids d'un tissu renforcé de fibres de verre tissées ;
(3) 25 % à 50 % en poids de charges particulaires inorganiques ;
(4) 1 % à 10 % en poids d'un coagent métallique ;
(5) 10 % à 30 % en poids d'un retardateur de flamme bromé ; et
(6) un initiateur de radicaux libres.

2. Composition de carte de circuit selon la revendication 1, dans laquelle la teneur en résine de base thermodurcissable est de préférence de 25 % à 32 % en poids.

3. Composition de carte de circuit selon la revendication 2, dans laquelle la teneur en résine thermodurcissable de polybutadiène représente 40 % à 90 % en poids des résines de base thermodurcissables totales.

4. Composition de carte de circuit selon la revendication 2, dans laquelle la teneur en composé cyclooléfinique avec au moins deux groupes vinyliques et/ou un terpolymère préparé à partir d'acide acrylique, d'acrylonitrile et de butadiène représente 10 % à 60 % en poids de la composition de résine de base thermodurcissable.

5. Composition de carte de circuit selon la revendication 2, dans laquelle la teneur en résine de base thermodurcissable de groupe d'addition 1,2 vinylique est de préférence supérieure à 80 % en poids de la résine thermodurcissable de polybutadiène à haute teneur vinylique.

6. Composition de carte de circuit selon la revendication 3, dans laquelle la proportion de résine thermodurcissable de polybutadiène avec un MW supérieur à 100 000 g/mol et celle avec un MW = 5000 à 10 000 g/mol est de 40 : 80 à 60 : 20.

7. Composition de carte de circuit selon la revendication 1, dans laquelle la teneur en tissu renforcé de fibres de verre tissées est de préférence égale à 10 % à 20 % en poids.

8. Composition de carte de circuit selon la revendication 1, dans laquelle la teneur en charges particulaires inorganiques est égale de préférence à 30 % à 45 % en poids.

9. Composition de carte de circuit selon la revendication 1, dans laquelle la teneur en coagent métallique est égale de préférence à 1 % à 5 % en poids.

10. Coagent métallique selon la revendication 9, où le coagent métallique est choisi parmi les complexes obtenus à partir de la réaction des métaux alcalins, des métaux alcalino-terreux ou de l'élément zinc avec l'acide acrylique.

11. Coagents métalliques selon la revendication 10, où celui qui est préféré est le diacrylate métallique ou le diméthacrylate métallique.

12. Composition de carte de circuit selon la revendication 1, dans laquelle la charge particulaire inorganique choisie parmi le dioxyde de titane, le titanate de baryum, le titanate de strontium ou la silice.

13. Composition de carte de circuit selon la revendication 12, dans laquelle la charge particulaire inorganique préférée est choisie parmi la silice amorphe ou la silice fondue.

14. Composition de carte de circuit selon la revendication 1, dans laquelle la teneur en retardateur de flamme bromé est de préférence 15 % à 25 % en poids.

15. Composition de carte de circuit selon la revendication 14, dans laquelle le retardateur de flamme bromé préféré est choisi parmi l'éthylène bistétrabromophtalimide, le tétradécabromodiphénoxy benzène ou le décabromodiphénoxy oxide.

16. Procédé pour produire une composition de carte de circuit à haute performance qui consiste à diluer le mélange suivant à une viscosité appropriée :
(1) 20 % à 35 % en poids d'un substrat de résine thermodurcissable qui contient :
(a) un mélange d'un polybutadiène à haute teneur vinylique (supérieure à 70 % en poids) un avec un MW > 100 000 g/mol et un avec un MW = 5000 à 10 000 g/mol,
(b) un polymère supérieur produit à partir de la polymérisation d'un composé cyclooléfinique avec au moins deux groupes vinyliques et/ou un terpolymère préparé à partir d'acide acrylique, d'acrylonitrile et de butadiène,
(2) 10 % à 30 % d'un tissu renforcé de fibres de verre tissées ;
(3) 25 % à 50 % en poids de charges particulaires inorganiques ;
(4) 1 % à 10 % en poids d'un coagent métallique ;
(5) 10 % à 30 % d'un retardateur de flamme bromé ; et
(6) un initiateur de radicaux libres ;
et à réaliser ensuite un pressage à chaud pour former une carte de circuit à la température de 170°C à 220°C et à la pression de 20 à 50 kg/cm².

17. Procédé selon la revendication 16, dans lequel le tissu de fibres de verre tissées semidurci dans une feuille de résine, puis 5 à 8 feuilles sont stratifiées et prises en sandwich entre deux feuilles de cuivre, elles sont ensuite pressées à chaud à une température optimale de 195°C et à la pression de 30 kg/cm².
